# EUROPEAN PATENT APPLICATION

(11) **EP 3 606 292 A1**
(43) Date of publication of application: **05.02.2020**
(21) Application number: 18772320.0
(22) Date of filing: 22.02.2018
(51) Int. Cl.: H05B 33/26, H01L 51/50, H05B 33/02, H05B 33/04, H05B 33/10

(54) **ORGANIC EL ELEMENT AND MANUFACTURING METHOD THEREFOR**

(30) Priority: 22.03.2017 JP 2017055718
(71) Applicant: Sumitomo Chemical Company, Limited, Tokyo 104-8260 (JP)
(72) Inventor: GODA Tadashi, Niihama-shi Ehime 792-0015 (JP)
(74) Representative: J A Kemp LLP
(86) International application number: PCT/JP2018/006444
(87) International publication number: WO 2018/173614

(57) **Abstract**

An organic EL element (1) includes a substrate (3) which has a first flat part (4A) and a second flat part (4B) that face each other, and a curved connecting part (4C) that connects an end of the first flat part (4A) to an end of the second flat part (4B), and in which the first flat part (4A),the second flat part (4B), and the connecting part (4C) are integrally formed; a first organic EL part (5) which is disposed on one surface (3a) of the first flat part (4A) and in which at least a first electrode layer (10), a first organic functional layer (12) and a second electrode layer (14) are disposed from the side of the one surface (3a); and a second organic EL part (7) which is disposed on one surface (3a) of the second flat part (4B) and in which at least a third electrode layer (16), a second organic functional layer (18) and a fourth electrode layer (14) are disposed from the side of the one surface (3a), and wherein the first electrode layer (10) and the third electrode layer (16) are not disposed on the connecting part (4C).

## Description

### Technical Field

The present invention relates to an organic EL element and a method for manufacturing an organic EL element.

### Background Art

Regarding conventional double-sided light emitting organic EL elements, for example, the element described in Patent Literature 1 is known. In the double-sided light emitting organic EL element described in Patent Literature 1, one EL sheet including a transparent sheet, a transparent electrode provided on the back of the transparent sheet, a light emitting layer provided on the back of the transparent electrode, a dielectric layer provided on the back of the light emitting layer, and a back electrode provided on the back of the dielectric layer is bent so that the sides of the back electrodes face each other.

### Citation List

### Patent Literature

[Patent Literature 1] Japanese Unexamined Patent Application Publication No. H8-203669

### Summary of Invention

### Technical Problem

A conventional double-sided light emitting organic EL element is configured by bending an EL sheet in which a transparent electrode, a light emitting layer, a dielectric layer and a back electrode are laminated on a transparent sheet. In such a configuration, respective layers are also bent in the part in which the EL sheet is bent. Thereby, in the conventional double-sided light emitting organic EL element, there is a risk of cracking occurring in the transparent electrode and light emission quality deteriorating. When cracking occurs in the transparent electrode, since short circuiting may occur in the transparent electrode and the back electrode, there is a risk of the element causing breakdown. That is, there is a risk of the reliability of the organic EL element being reduced.

According to one aspect of the present invention, in the double-sided light emission configuration, there are provided an organic EL element that can minimize reduction in reliability and a method for manufacturing an organic EL element.

### Solution to Problem

An organic EL element according to one aspect of the present invention includes a substrate having flexibility and having a first flat part and a second flat part that face each other, and a curved connecting part that connects an end of the first flat part to an end of the second flat part, and in which the first flat part, the second flat part, and the connecting part are integrally formed; a first organic EL part which is disposed on one surface that faces the second flat part of the first flat part and in which at least a first electrode layer, a first organic functional layer, and a second electrode layer are disposed from the side of the one surface; and a second organic EL part which is disposed on one surface that faces the first flat part of the second flat part and in which at least a third electrode layer, a second organic functional layer and a fourth electrode layer are disposed from the side of the one surface, wherein at least one of the first electrode layer and the third electrode layer, and the second electrode layer and the fourth electrode layer is not disposed on the connecting part.

In the organic EL element according to one aspect of the present invention, the first organic EL part is disposed in the first flat part of the substrate, and the second organic EL part is disposed in the second flat part of the substrate. In such a configuration, at least one of the first electrode layer and the third electrode layer, and the second electrode layer and the fourth electrode layer is not formed in the connecting part of the substrate. Thereby, in the organic EL element, even if the substrate is bent to form an organic EL element, it is possible to prevent the occurrence of cracking in the first anode layer and the second anode layer in the connecting part. Therefore, in the organic EL element, no short circuiting occurs in the first electrode layer and the second electrode layer, and in the third electrode layer and the fourth electrode layer. As a result, in the organic EL element, in the double-sided light emission configuration, it is possible to minimize reduction in reliability.

In one embodiment, the first electrode layer and the third electrode layer are not disposed on the connecting part, and the second electrode layer and the fourth electrode layer are integrally formed, and may be disposed over the first flat part, the second flat part and the connecting part. In such a configuration, since the second electrode layer and the fourth electrode layer are electrically connected, one terminal connected to the second electrode layer and the fourth electrode layer can be provided. Thereby, in the organic EL element, the configuration can be simplified. When an organic EL element is manufactured, after the first electrode layer and the first organic functional layer are formed on the first flat part and the third electrode layer and the second organic functional layer are formed on the second flat part, the second electrode layer and the fourth electrode layer are formed on the first organic functional layer and the second organic functional layer. Thus, the second electrode layer and the fourth electrode layer can be formed in one step. Therefore, the manufacturing can be simplified.

In one embodiment, the first organic functional layer and the second organic functional layer are integrally formed, and may be disposed over the first flat part, the second flat part and the connecting part. When an organic EL element is manufactured, after the first electrode layer is formed on the first flat part and the third electrode layer is formed on the second flat part, the first organic functional layer and the second organic functional layer are formed on the first electrode layer and the third electrode layer. Thus, the first organic functional layer and the second organic functional layer can be formed in one step. Therefore, the manufacturing can be simplified.

In one embodiment, the first organic functional layer and the second organic functional layer may have different light emission colors. In such a configuration, in the double-sided light emission configuration, in the first organic EL part and the second organic EL part, light with different light emission colors can be emitted.

In one embodiment, a sealing part may be provided between the first organic EL part and the second organic EL part. Thereby, it is possible to electrically insulate between the second electrode layer of the first organic EL part and the fourth electrode layer of the second organic EL part more reliably.

A method for manufacturing an organic EL element according to one aspect of the present invention includes a forming step of forming a first organic EL part in which at least a first electrode layer, a first organic functional layer and a second electrode layer are disposed and a second organic EL part in which at least a third electrode layer, a second organic functional layer and a fourth electrode layer are disposed on one main surface of a substrate having flexibility at predetermined intervals; and a step of bending the substrate with an area between the first organic EL part and the second organic EL part as the bent part so that the first organic EL part and the second organic EL part face each other, wherein, in the forming step, at least one of the first electrode layer and the third electrode layer, and the second electrode layer and the fourth electrode layer is not formed on the bent part.

In the method for manufacturing an organic EL element according to one aspect of the present invention, the first organic EL part and the second organic EL part are formed on one main surface of the substrate at predetermined intervals, and the substrate is bent with an area between the first organic EL part and the second organic EL part as the bent part so that the first organic EL part and the second organic EL part face each other. In this case, at least one of the first electrode layer and the third electrode layer, and the second electrode layer and the fourth electrode layer is not formed on the bent part. In the organic EL element manufactured in this manner, the first electrode layer of the first organic EL part and the third electrode layer of the second organic EL part are not formed on the connecting part of the substrate. Thereby, in the organic EL element, even if the substrate is bent to form an organic EL element, it is possible to prevent the occurrence of cracking in the first electrode layer and the third electrode layer in the connecting part. Therefore, in the organic EL element, no short circuiting occurs in the first electrode layer and the second electrode layer, and in the third electrode layer and the fourth electrode layer. As a result, in the organic EL element manufactured by the method for manufacturing an organic EL element, in the double-sided light emission configuration, it is possible to minimize reduction in reliability.

In one embodiment, after the first electrode layer and the first organic functional layer, and the third electrode layer and the second organic functional layer are formed on one main surface of the substrate, the second electrode layer and the fourth electrode layer may be integrally formed over the first organic functional layer, the second organic functional layer, and one main surface between the first electrode layer and the third electrode layer. In this method, after the first electrode layer and the first organic functional layer are formed on the first flat part and the third electrode layer and the second organic functional layer are formed on the second flat part, the second electrode layer and the fourth electrode layer are formed on the first organic functional layer and the second organic functional layer. Thus, the second electrode layer and the fourth electrode layer can be formed in one step. Therefore, the manufacturing can be simplified. Since the second electrode layer and the fourth electrode layer are electrically connected, one terminal connected to the second electrode layer and the fourth electrode layer can be provided. Thereby, in the organic EL element manufactured by the method for manufacturing an organic EL element, the configuration can be simplified.

### Advantageous Effects of Invention

According to one aspect of the present invention, in a configuration of the double-sided light emission, it is possible to minimize reduction in reliability.

### Brief Description of Drawings

FIG. 1 is a perspective view of an organic EL element according to an embodiment.
FIG. 2 is a diagram showing a cross-sectional configuration of the organic EL element.
FIG. 3 is a diagram showing a cross-sectional configuration of the organic EL element.
FIG. 4(a), FIG. 4(b) and FIG. 4(c) are diagrams showing a method for manufacturing an organic EL element.

### Description of Embodiments

Exemplary embodiments of the present invention will be described below in detail with reference to the appended drawings. The same or corresponding components are denoted with the same reference numerals in the following description, and redundant descriptions thereof will be omitted.

### [Structure of organic EL element]

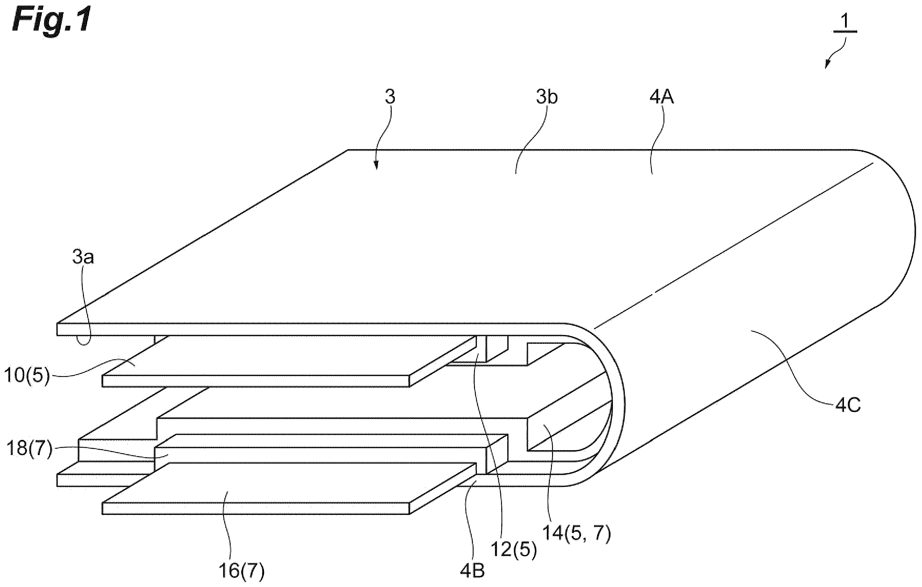

As shown in FIG. 1 to FIG. 3, an organic EL element 1 includes a substrate 3, a first organic EL part 5, a second organic EL part 7, and a sealing part 9. In FIG. 1, the sealing part 9 is not shown. The organic EL element 1 of the present embodiment is a double-sided light emitting element.

The substrate 3 has one main surface 3a and the other main surface 3b. The other main surface 3b is a light emitting surface in the organic EL element 1. The substrate 3 has a first flat part 4A, a second flat part 4B, and a connecting part 4C. Each of the first flat part 4A and the second flat part 4B has a flat shape. The first flat part 4A and the second flat part 4B face each other. Thereby, in the first flat part 4A and the second flat part 4B, the one main surfaces 3a face each other. The connecting part 4C connects the end of the first flat part 4A to the end of the second flat part 4B. The connecting part 4C has a curved shape (a shape having a predetermined curvature). The substrate 3 is configured by bending one member, and the first flat part 4A, the second flat part 4B, and the connecting part 4C are integrally formed. In this specification, the expression "integrally formed" means that respective parts are formed of one member and there is no boundary between the parts.

The first organic EL part 5 includes an anode layer (first electrode layer) 10, an organic functional layer (first organic functional layer) 12, and a cathode layer (second electrode layer) 14. The first organic EL part 5 is disposed on the one main surface 3 a in the first flat part 4A of the substrate 3. In the first organic EL part 5, the anode layer 10, the organic functional layer 12, and the cathode layer 14 are disposed in this order from the side of the one main surface 3a of the substrate 3. In the present embodiment, the first organic EL part 5 is a part in which the anode layer 10, the organic functional layer 12, and the cathode layer 14 overlap in a lamination direction (a part that becomes a light emitting area).

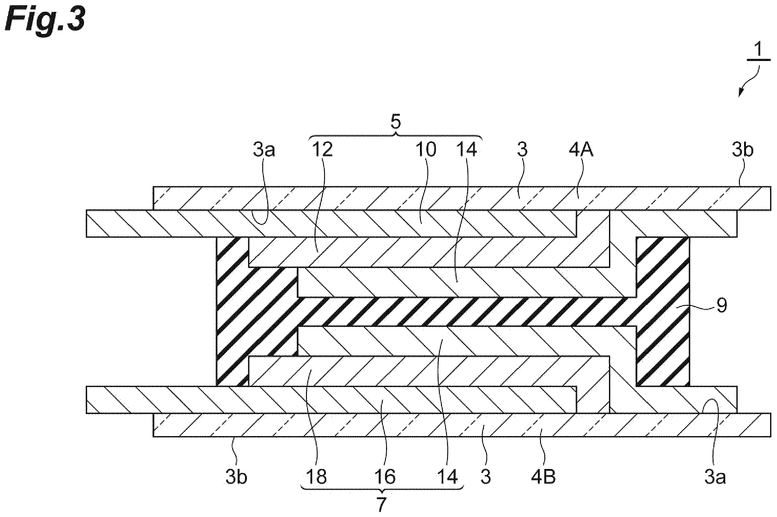

The anode layer 10 and the organic functional layer 12 of the first organic EL part 5 are disposed only on the first flat part 4A of the substrate 3. That is, the anode layer 10 and the organic functional layer 12 are not disposed on the connecting part 4C. As shown in FIG. 1 and FIG. 3, one end of the anode layer 10 protrudes from the edge from the substrate 3 in an extension direction of the substrate 3. The protrusion part of the anode layer 10 functions as a connecting terminal.

The second organic EL part 7 includes an anode layer (third electrode layer) 16, an organic functional layer (second organic functional layer) 18, and a cathode layer (fourth electrode layer) 14. The second organic EL part 7 is disposed on the one main surface 3a in the second flat part 4B of the substrate 3. In the second organic EL part 7, the anode layer 16, the organic functional layer 18, and the cathode layer 14 are disposed in this order from the side of the one main surface 3a of the substrate 3. In the present embodiment, the second organic EL part 7 is a part in which the anode layer 16, the organic functional layer 18, and the cathode layer 14 overlap in a lamination direction.

The anode layer 16 and the organic functional layer 18 of the second organic EL part 7 are disposed only on the second flat part 4B of the substrate 3. That is, the anode layer 16 and the organic functional layer 18 are not disposed on the connecting part 4C. As shown in FIG. 1 and FIG. 3, one end of the anode layer 16 protrudes from the edge of the substrate 3 in an extension direction of the substrate 3. The protrusion part of the anode layer 16 functions as a connecting terminal.

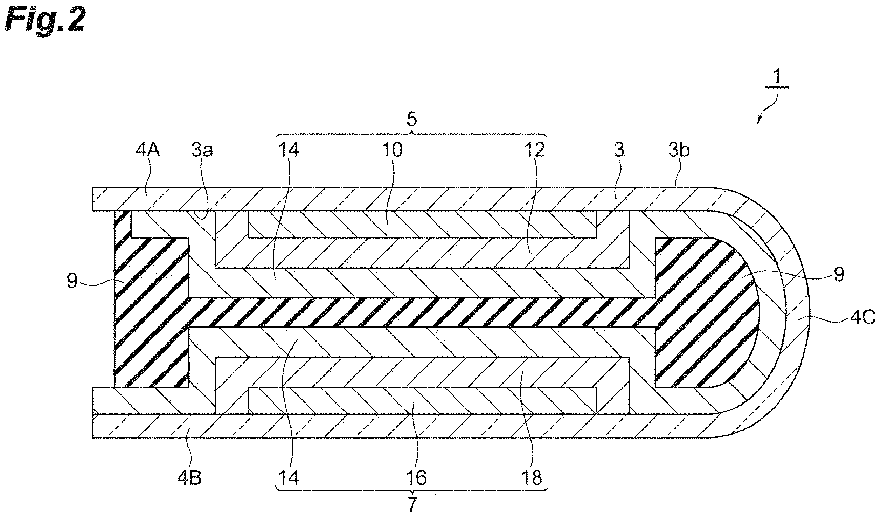

As shown in FIG. 2, the cathode layer 14 is common to the first organic EL part 5 and the second organic EL part 7. The cathode layer 14 is disposed over the first flat part 4A, the second flat part 4B, and the connecting part 4C. Specifically, the cathode layer 14 is disposed on the organic functional layer 12, on the organic functional layer 18, and on the one main surface 3a. The cathode layer 14 is disposed on the one main surface 3a in the connecting part 4C. The cathode layer 14 is curved along the connecting part 4C in the connecting part 4C.

In the organic EL element 1, the first organic EL part 5 and the second organic EL part 7 are disposed to face each other. Specifically, the first organic EL part 5 and the second organic EL part 7 are disposed to face each other in a direction in which the first flat part 4A and the second flat part 4B of the substrate 3 face each other. The first organic EL part 5 emits light toward the side of the first flat part 4A of the substrate 3 (the side opposite to the second organic EL part 7). The second organic EL part 7 emits light toward the side of the second flat part 4B of the substrate 3 (the side opposite to the first organic EL part 5). Thereby, in the organic EL element 1, light is emitted from the other main surface 3b of the substrate 3 toward sides opposite to each other. In the organic EL element 1, in the first organic EL part 5 and the second organic EL part 7, light emission colors may be the same or light emission colors may be different from each other. That is, light emission colors of light emitting layers (to be described below) in the organic functional layer 12 and the organic functional layer 18 may be the same as or different from each other.

The organic EL element 1 has the sealing part 9 between the first organic EL part 5 and the second organic EL part 7. The sealing part 9 seals the first organic EL part 5 and the second organic EL part 7. The sealing part 9 is provided in a space formed by the cathode layer 14. The sealing part 9 is formed using, for example, a thermosetting adhesive such as CELVENUS H (commercially available from Daicel Corporation).

Subsequently, the substrate 3 of the organic EL element 1 and respective parts of the first organic EL part 5 and the second organic EL part 7 will be described in detail.

### [Substrate]

The substrate 3 is made of a resin having transparency with respect to visible light (light with a wavelength of 400 nm to 800 nm). The substrate 3 is a film-like substrate (a flexible substrate and a substrate having flexibility). The thickness of the substrate 3 is, for example, 30 µm or more and 500 µm or less.

The substrate 3 is, for example, a plastic film. Examples of materials of the substrate 3 include polyether sulfone (PES); polyester resins such as polyethylene terephthalate (PET) and polyethylene naphthalate (PEN); polyolefin resins such as polyethylene (PE), polypropylene (PP), and cyclic polyolefins; polyamide resins; polycarbonate resins; polystyrene resins; polyvinyl alcohol resins; saponified products of ethylene-vinyl acetate copolymers; polyacrylonitrile resins; acetal resins; polyimide resins; and epoxy resins.

Regarding the material of the substrate 3, among the above resins, a polyester resin or a polyolefin resin is preferable and polyethylene terephthalate or polyethylene naphthalate is more preferable because then the heat resistance is high, the coefficient of linear expansion is low, and the manufacturing costs are low. These resins may be used alone and two or more thereof may be used in combination.

A gas barrier layer or a water barrier layer may be disposed on the one main surface 3a of the substrate 3. A light extraction film may be provided on the other main surface 3b of the substrate 3.

### [Anode layer]

The anode layer 10 and the anode layer 16 have the same configuration. An example of the anode layer 10 will be described below in detail. An electrode layer exhibiting light transmission is used for the anode layer 10. Regarding an electrode exhibiting light transmission, a thin film made of a metal oxide, a metal sulfide or a metal having high electrical conductivity can be used, and a thin film having high light transmittance is suitably used. For example, thin films made of indium oxide, zinc oxide, tin oxide, indium tin oxide (abbreviation ITO), indium zinc oxide (abbreviation IZO), gold, platinum, silver, copper, or the like are used. Among these, a thin film made of ITO, IZO, or tin oxide is suitably used.

Regarding the anode layer 10, a transparent conductive film made of an organic material such as polyaniline and derivatives thereof, polythiophene and derivatives thereof may be used. Regarding the anode layer 10, an electrode obtained by patterning the above exemplified metals or metal alloys in a mesh shape or an electrode in which nanowires containing silver are formed into a network shape may be used.

The thickness of the anode layer 10 can be determined in consideration of light transmission, electrical conductivity, and the like. The thickness of the anode layer 10 is generally 10 nm to 10 µm, preferably 20 nm to 1 µm, and more preferably 50 nm to 200 nm.

Examples of a method for forming the anode layer 10 include a dry film forming method such as a vacuum deposition method, a sputtering method, and an ion plating method, and a coating method such as an inkjet method, a slit coating method, a gravure printing method, a screen printing method, and a spray coating method. In the anode layer 10, additionally, a pattern can be formed using a photolithographic method, a dry etching method, a laser trimming method, or the like. Direct coating is performed on the substrate 3 using a coating method, and thus a pattern can be formed without using a photolithographic method, a dry etching method, a laser trimming method, or the like.

### [Organic functional layer]

The organic functional layer 12 and the organic functional layer 18 have the same configuration. An example of the organic functional layer 12 will be described below in detail. The organic functional layer 12 includes a light emitting layer. The organic functional layer 12 generally contains a light emitting material that mainly emits fluorescence and/or phosphorescence or a light emitting material and a dopant material for a light emitting layer that assists the light emitting material. For example, the dopant material for a light emitting layer is added to improve luminous efficiency or change a light emission wavelength. The light emitting material that emits fluorescence and/or phosphorescence may be a low-molecular-weight compound or a high-molecular-weight compound. Examples of organic materials constituting the organic functional layer 12 include a light emitting material that emits fluorescence and/or phosphorescence such as the following dye materials, metal complex materials, and polymeric materials and the following dopant materials for a light emitting layer.

### (Dye materials)

Examples of dye materials include cyclopentamine and derivatives thereof, tetraphenylbutadiene and derivatives thereof, triphenylamine and derivatives thereof, oxadiazole and derivatives thereof, pyrazoloquinoline and derivatives thereof, distyrylbenzene and derivatives thereof, distyrylarylene and derivatives thereof, pyrrole and derivatives thereof, thiophene compounds, pyridine compounds, perinone and derivatives thereof, perylene and derivatives thereof, oligothiophene and derivatives thereof, oxadiazole dimers, pyrazoline dimers, quinacridone and derivatives thereof, and coumarin and derivatives thereof.

### (Metal complex materials)

Examples of metal complex materials include metal complexes which contains a rare earth metal such as Tb, Eu, and Dy, or Al, Zn, Be, Pt, or Ir as a central metal, and have a oxadiazole, thiadiazole, phenylpyridine, phenylbenzimidazole, or quinoline structure or the like in a ligand. Examples of metal complexes include metal complexes emitting light in a triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (Polymeric materials)

Examples of polymeric materials include polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinylcarbazole and derivatives thereof, and materials obtained by polymerizing the above dye materials or metal complex materials.

### (Dopant materials for a light emitting layer)

Examples of dopant materials for a light emitting layer include perylene and derivatives thereof, coumarin and derivatives thereof, rubrene and derivatives thereof, quinacridone and derivatives thereof, squarylium and derivatives thereof, porphyrin and derivatives thereof, styryl dyes, tetracene and derivatives thereof, pyrazolone and derivatives thereof, decacyclene and derivatives thereof, and phenoxazone and derivatives thereof.

The thickness of the organic functional layer 12 and the organic functional layer 18 is generally about 2 nm to 200 nm. For example, the organic functional layer 12 is formed by a coating method using a coating solution (for example, an ink) containing the above light emitting material. A solvent for a coating solution containing a light emitting material is not limited as long as it dissolves the light emitting material. The above light emitting material may be formed by vacuum deposition.

### [Cathode layer]

Regarding the material of the cathode layer 14, for example, alkali metals, alkaline earth metals, transition metals, and metals in Group 13 in the periodic table can be used. Regarding the material of the cathode layer 14, specifically, for example, a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the above metals, an alloy of one or more of the above metals and one or more of gold, silver, platinum, copper, manganese, titanium, cobalt, nickel, tungsten, and tin, or graphite or a graphite intercalation compound is used. Examples of alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

For the cathode layer 14, for example, a transparent conductive electrode made of a conductive metal oxide, a conductive organic material, or the like can be used. Specific examples of conductive metal oxides include indium oxide, zinc oxide, tin oxide, ITO, and IZO, and examples of conductive organic materials include polyaniline and derivatives thereof, polythiophene and derivatives thereof. The cathode layer 14 may have a laminate configuration in which two or more layers are laminated. An electron injection layer to be described below may be used as the cathode layer 14.

The thickness of the cathode layer 14 is set in consideration of the electrical conductivity and durability. The thickness of the cathode layer 14 is generally 10 nm to 10 µm, preferably 20 nm to 1 µm, and more preferably 50 nm to 500 nm.

Examples of a method for forming the cathode layer 14 include coating methods such as an inkjet method, a slit coating method, a gravure printing method, a screen printing method, and a spray coating method, a vacuum deposition method, a sputtering method, and a lamination method for thermocompression bonding a metal thin film.

### [Method for manufacturing an organic EL element]

Subsequently, a method for manufacturing an organic EL element 1 having the above configuration will be described.

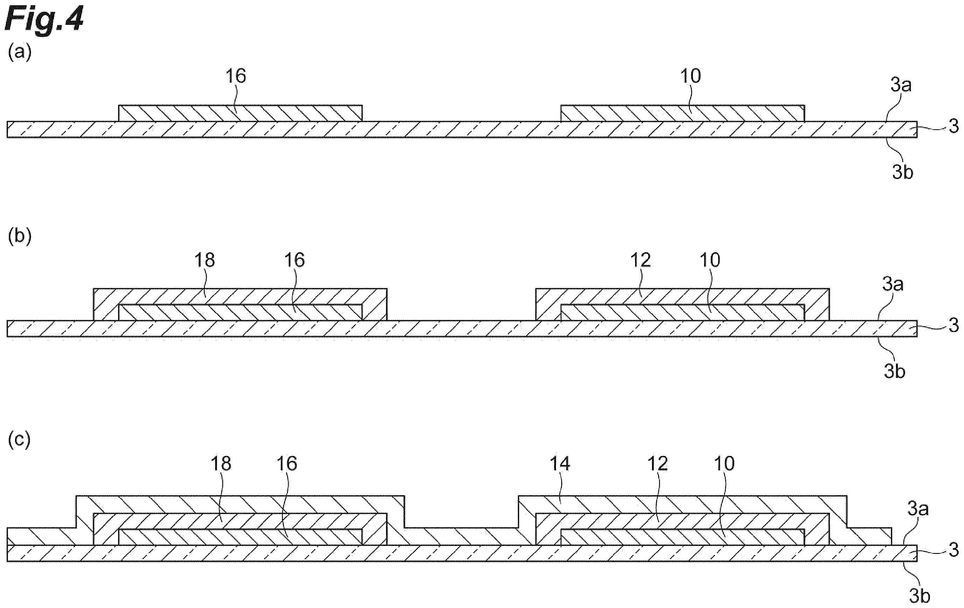

When the organic EL element 1 is manufactured, as shown in FIG. 4(a), the anode layer 10 and the anode layer 16 are formed on the one main surface 3a of the substrate 3. The anode layer 10 and the anode layer 16 are formed at predetermined intervals. The anode layer 10 and the anode layer 16 can be formed by a formation method exemplified in the description of the anode layer 10 and the anode layer 16.

Subsequently, as shown in FIG. 4(b), the organic functional layer 12 is formed on the anode layer 10, and the organic functional layer 18 is formed on the anode layer 16. The organic functional layer 12 and the organic functional layer 18 can be formed by a formation method exemplified in the description of the organic functional layer 12 and the organic functional layer 18.

Subsequently, as shown in FIG. 4(c), the cathode layer 14 is formed. The cathode layer 14 is formed over the organic functional layer 12, the organic functional layer 18, and the one main surface 3a including an area between the anode layer 10 and the anode layer 16. The cathode layer 14 is formed with a certain thickness throughout the entire structure. Thereby, the first organic EL part 5 and the second organic EL part 7 are formed on the substrate 3 at predetermined intervals (forming step).

Subsequently, the sealing part 9 is formed on the cathode layer 14. Then, the substrate 3 is bent with an area between the first organic EL part 5 and the second organic EL part 7 as the bent part so that the first organic EL part 5 and the second organic EL part 7 face each other. Thereby, as shown in FIG. 1, the organic EL element 1 is manufactured.

As described above, in the organic EL element 1 according to the present embodiment, the first organic EL part 5 is disposed in the first flat part 4A of the substrate 3, and the second organic EL part 7 is disposed in the second flat part 4B of the substrate 3. In such a configuration, the anode layer 10 of the first organic EL part 5 and the anode layer 16 of the second organic EL part 7 are not formed on the connecting part 4C of the substrate 3. Thereby, in the organic EL element 1, even if the substrate 3 is bent to form the organic EL element 1, it is possible to prevent the occurrence of cracking in the anode layer 10 and the anode layer 16 in the connecting part 4C. Therefore, in the organic EL element 1, no short circuiting occurs in the anode layer 10 and the cathode layer 14, and in the anode layer 16 and the cathode layer 14. As a result, in the organic EL element 1, in the double-sided light emission configuration, it is possible to minimize reduction in reliability.

In the organic EL element 1 according to the present embodiment, the cathode layers 14 of the first organic EL part 5 and the second organic EL part 7 are integrally formed and are disposed over the first flat part 4A, the second flat part 4B and the connecting part 4C. In such a configuration, since the cathode layers 14 of the first organic EL part 5 and the second organic EL part 7 are electrically connected, one terminal connected to the cathode layer 14 can be provided. Thereby, in the organic EL element 1, the configuration can be simplified. When the organic EL element 1 is manufactured, the anode layer 10 and the organic functional layer 12 are formed on the first flat part 4A, and the anode layer 16 and the organic functional layer 18 are formed on the second flat part 4B, and the cathode layer 14 is then formed on the organic functional layer 12 and the organic functional layer 18. Thus, the cathode layer 14 can be formed in one step. Therefore, in the organic EL element 1, the manufacturing can be simplified.

In the organic EL element 1 according to the present embodiment, the organic functional layer 12 and the organic functional layer 18 may have different light emission colors. In such a configuration, in the double-sided light emission configuration, light emission colors of respective surfaces can be different from each other.

While embodiments of the present invention have been described above, the present invention is not necessarily limited to the above embodiments, and various modifications can be made without departing from the spirit and scope of the invention.

For example, in the above embodiment, the organic EL element 1 in which, in the first organic EL part 5, the organic functional layer 12 including a light emitting layer is disposed between the anode layer 10 and the cathode layer 14, and in the second organic EL part 7, the organic functional layer 18 is disposed between the anode layer 16 and the cathode layer 14 has been exemplified. However, the configuration of the organic functional layer 12 and the organic functional layer 18 is not limited thereto. The organic functional layer 12 and the organic functional layer 18 each may have the following configuration.
(a) (anode layer)/light emitting layer/(cathode layer)
(b) (anode layer)/hole injection layer/light emitting layer/(cathode layer)
(c) (anode layer)/hole injection layer/light emitting layer/electron injection layer/(cathode layer)
(d) (anode layer)/hole injection layer/light emitting layer/electron transport layer/electron injection layer/(cathode layer)
(e) (anode layer)/hole injection layer/hole transport layer/light emitting layer/(cathode layer)
(f) (anode layer)/hole injection layer/hole transport layer/light emitting layer/electron injection layer/(cathode layer)
(g) (anode layer)/hole injection layer/hole transport layer/light emitting layer/electron transport layer/electron injection layer/(cathode layer)
(h) (anode layer)/light emitting layer/electron injection layer/(cathode layer)
(i) (anode layer)/light emitting layer/electron transport layer/electron injection layer/(cathode layer)

Here, the symbol "/" indicates that layers between which the symbol "/" is interposed are laminated adjacent to each other. The configuration shown in the above (a) is a configuration of the organic EL element 1 in the above embodiment.

Regarding materials of a hole injection layer, a hole transport layer, an electron transport layer and an electron injection layer, known materials can be used. The hole injection layer, the hole transport layer, the electron transport layer, and the electron injection layer can be formed by, for example, a coating method as in the organic functional layer 12 and the organic functional layer 18.

The electron injection layer may contain an alkali metal or an alkaline earth metal, or an oxide or fluoride of an alkali metal or an alkaline earth metal. Examples of a film forming method of an electron injection layer include a coating method and a vacuum deposition method. In the case of the oxide and fluoride, the thickness of the electron injection layer is preferably 0.5 nm to 20 nm. Particularly, when insulation properties are strong, the electron injection layer is preferably a thin film in order to reduce increase in the drive voltage of the organic EL element 1, and the thickness thereof is preferably, for example, 0.5 nm to 10 nm, and more preferably 2 nm to 7 nm in consideration of electron injection properties.

The organic EL element 1 may include a single organic functional layer 12 and 18 or two or more organic functional layers 12 and 18. In any one of the above (a) to (i) layer configuration, when a lamination structure disposed between the anode layer 10 and the cathode layer 14, and between the anode layer 16 and the cathode layer 14 is set as a "structural unit A," as a configuration of an organic EL element including the two organic functional layers 12 and 18, for example, a layer configuration shown in the following (j) may be exemplified. Two layer configurations (structural unit A) may be the same as or different from each other.

### (j) anode layer/(structural unit A)/charge generation layer/(structural unit A)/cathode layer

The charge generation layer is a layer that generates a hole and an electron when an electric field is applied. Examples of the charge generation layer include a thin film made of vanadium oxide, ITO, molybdenum oxide, or the like.

When "(structural unit A)/charge generation layer" is set as a "structural unit B," as a configuration of an organic EL element including three or more organic functional layers 12 and 18, for example, a layer configuration shown in the following (k) may be exemplified.

### (k) anode layer/(structural unit B)x/(structural unit A)/cathode layer

The symbol "x" denotes an integer of 2 or more, and "(structural unit B)x" denotes a laminate in which x (structural units B) are laminated. A plurality of (structural unit B) layer configurations may be the same as or different from each other.

A plurality of organic functional layers 12 and 18 may be directly laminated without providing the charge generation layer to form an organic EL element.

In the above embodiment, a form in which the cathode layers 14 of the first organic EL part 5 and the second organic EL part 7 are integrally formed, that is, a form in which the second electrode layer and the fourth electrode layer are the cathode layer 14, has been exemplified. However, the cathode layers (the second electrode layer and the fourth electrode layer) may be formed independently (electrically insulated). In this case, the cathode layer is not disposed on the connecting part 4C of the substrate 3. Also in such a configuration, the anode layer 10 of the first organic EL part 5 and the anode layer 16 of the second organic EL part 7 are not formed on the connecting part 4C of the substrate 3. Thereby, in the organic EL element, even if the substrate 3 is bent to form the organic EL element 1, it is possible to prevent the occurrence of cracking in the anode layer 10 and the anode layer 16 in the connecting part 4C. Therefore, in the double-sided light emission configuration, it is possible to minimize reduction in reliability.

In the above embodiment, a form in which the cathode layer 14 is formed on the connecting part 4C of the substrate 3, the anode layer 10 of the first organic EL part 5 and the anode layer 16 of the second organic EL part 7 are not formed, that is, a form in which the first electrode layer and the third electrode layer are not formed on the connecting part 4C of the substrate 3 has been exemplified. However, in the present invention, preferably, at least one of the anode layer (the first electrode layer and the third electrode layer) and the cathode layer (the second electrode layer and the fourth electrode layer) is not disposed on the connecting part. For example, a form in which the anode layer is formed on the connecting part 4C and the cathode layer (the second electrode layer and the fourth electrode layer) is not formed may be used. In this case, anode layers of the first organic EL part 5 and the second organic EL part 7 are integrally formed.

In the above embodiment, a form having the sealing part 9 has been exemplified. However, the organic EL element may not have the sealing part 9.

In the above embodiment, a form in which the first electrode layer and the third electrode layer are the anode layer, and the second electrode layer and the fourth electrode layer are the cathode layer has been exemplified. However, in the organic EL element, the first electrode layer and the third electrode layer may be the cathode layer, and the second electrode layer and the fourth electrode layer may be the anode layer.

In the above embodiment, a form in which the first organic functional layer is formed on only on the first flat part and the second organic functional layer is formed on only on the second flat part, that is, a form in which the first organic functional layer and the second organic functional layer are not disposed on the connecting part 4C has been exemplified. However, in the organic EL element, the organic functional layer may be formed on the connecting part 4C. In this case, the first organic functional layer of the first flat part, the organic functional layer of the connecting part 4C, and the second organic functional layer of the second flat part are preferably integrally formed.

### Reference Signs List

- 1: Organic EL element
- 3: Substrate
- 3a: One main surface
- 4A: First flat part
- 4B: Second flat part
- 4C: Connecting part
- 5: First organic EL part
- 7: Second organic EL part
- 10: Anode layer (first electrode layer)
- 12: Organic functional layer (first organic functional layer)
- 14: Cathode layer (second electrode layer, fourth electrode layer)
- 16: Anode layer (third electrode layer)
- 18: Organic functional layer (second organic functional layer)

## Claims

1. An organic EL element, comprising:
a substrate having flexibility and having a first flat part and a second flat part that face each other, and a curved connecting part that connects an end of the first flat part to an end of the second flat part, and in which the first flat part, the second flat part, and the connecting part are integrally formed;
a first organic EL part which is disposed on one surface that faces the second flat part of the first flat part and in which at least a first electrode layer, a first organic functional layer, and a second electrode layer are disposed from the side of the one surface; and
a second organic EL part which is disposed on one surface that faces the first flat part of the second flat part and in which at least a third electrode layer, a second organic functional layer and a fourth electrode layer are disposed from the side of the one surface,
wherein at least one of the first electrode layer and the third electrode layer, and the second electrode layer and the fourth electrode layer is not disposed on the connecting part.

2. The organic EL element according to claim 1,
wherein the first electrode layer and the third electrode layer are not disposed on the connecting part, and
wherein the second electrode layer and the fourth electrode layer are integrally formed, and are disposed over the first flat part, the second flat part, and the connecting part.

3. The organic EL element according to claim 1 or 2,
wherein the first organic functional layer and the second organic functional layer are integrally formed, and disposed over the first flat part, the second flat part, and the connecting part.

4. The organic EL element according to any one of claims 1 to 3, wherein the first organic functional layer and the second organic functional layer have different light emission colors.

5. The organic EL element according to any one of claims 1 to 4, wherein a sealing part is provided between the first organic EL part and the second organic EL part.

6. A method for manufacturing an organic EL element, comprising:
a forming step forming a first organic EL part in which at least a first electrode layer, a first organic functional layer and a second electrode layer are disposed and a second organic EL part in which at least a third electrode layer, a second organic functional layer and a fourth electrode layer are disposed on one main surface of a substrate having flexibility at predetermined intervals; and
a step of bending the substrate with an area between the first organic EL part and the second organic EL part as the bent part so that the first organic EL part and the second organic EL part face each other,
wherein, in the forming step, at least one of the first electrode layer and the third electrode layer, and the second electrode layer and the fourth electrode layer is not formed on the bent part.

7. The method for manufacturing an organic EL element according to claim 6,
wherein, after the first electrode layer and the first organic functional layer, and the third electrode layer and the second organic functional layer are formed on the one main surface of the substrate, the second electrode layer and the fourth electrode layer are integrally formed over the first organic functional layer, the second organic functional layer and the one main surface between the first electrode layer and the third electrode layer.
